# EUROPEAN PATENT APPLICATION

(11) **EP 2 309 220 A1**
(43) Date of publication of application: **13.04.2011**
(21) Application number: 09172120.9
(22) Date of filing: 02.10.2009
(51) Int. Cl.: G01B 7/06, C23C 14/54

(54) **Coating thickness measuring device and method**

(71) Applicant: Applied Materials, Inc., Santa Clara, CA 95054 (US)
(72) Inventor: Schramm, Sven, 63796 Kahl (DE); Maurer, Philipp, 63820 Elsenfeld (DE)
(74) Representative: Zimmermann & Partner

(57) **Abstract**

A thickness measuring device for measuring the thickness of a layer on a substrate surface of a substrate is provided, including multiple piezoelectric crystal elements, which are arranged in an array corresponding to multiple positions on the substrate surface and which are adapted to monitor the deposition rate of a vapor to be deposited on the substrate surface.

## Description

### TECHNICAL FIELD

Embodiments relate to a thickness measuring device for measuring the thickness of a layer on a substrate surface of a substrate, a coating installation, a method of measuring the thickness of a layer on a substrate surface of a substrate, and a use of a thickness measuring device.

### BACKGROUND ART

For solar cell production, so called bulk technologies or thin-film technologies may be applied, the former utilizing bulk semiconductor wafers, the latter resulting in thin-film solar cells. The most prevalent bulk material of solar cells is crystalline silicon, for instance mono-crystalline silicon (c-Si), or multi-crystalline silicon (mc-Si).

A typical solar cell production process based on mc-Si may include for instance some of the following steps: Removal of saw-damage from mc-Si wafers by etching; emitter formation by heat treatment in POCl₃ ambient; removal of resulting phosphorus silicate glass (PSG); front side and/or back side passivation; deposition of a front side anti-reflection coating, e.g. by Plasma Enhanced Chemical Vapor Deposition (PECVD); deposition of rear side metallization and front contact grid lines; and annealing for rear side metal interdiffusion and firing the front contact grid lines.

Electrical contacts for wafer based solar cells are typically created by screen printing. Thereby, metal pastes, for instance an aluminum paste for backside contacts, are applied on a solar cell precursor and further processed to obtain the desired electrical contacts. Deposition of electrical contacts on a semiconductor element by PVD, such as evaporation or sputtering, is another possibility of forming electrical contacts on wafers, as described in EP 2031659 A1 and US 2009061627 A1, which are incorporated herein by reference. In case of forming electrical contacts by PVD, layers with a thickness of several microns can be formed.

The thickness uniformity of a layer deposited on a substrate can vary across the substrate surface. The layer thickness and uniformity of films on substrates, such as anti-reflection coatings on a solar cell substrate surface, are typically controlled by means of optical transmission or sheet resistance measurements. Such measurements can be performed online in many deposition systems, for instance in inline deposition systems.

### SUMMARY

In light of the above, a thickness measuring device according to claim 1, a coating installation according to claim 6, a method according to claim 7, and a use of a thickness measuring device according to claim 15 are provided.

According to one embodiment, a thickness measuring device for measuring the thickness of a layer on a substrate surface of a substrate is provided, including multiple piezoelectric crystal elements, which are arranged in an array corresponding to multiple positions on the substrate surface and which are adapted to monitor the deposition rate of a vapor to be deposited on the substrate surface.

According to a further embodiment, a coating installation including a thickness measuring device for measuring the thickness of a layer on a substrate surface of a substrate is provided, the thickness measuring device including multiple piezoelectric crystal elements, which are arranged in an array corresponding to multiple positions on the substrate surface and which are adapted to monitor the deposition rate of a vapor to be deposited on the substrate surface.

In a further embodiment, a method of measuring the thickness of a layer on a substrate surface of a substrate is provided, including providing multiple piezoelectric crystal elements arranged in an array corresponding to multiple positions on the substrate surface, producing a vapor of material to be deposited on the substrate surface, and measuring the deposition rate of the vapor by means of the multiple piezoelectric crystal elements.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of embodiments can be understood in detail, a more particular description of embodiments of the invention, briefly summarized above, may be had by reference to examples of embodiments. The accompanying drawings relate to embodiments of the invention and are described in the following. Some of the above mentioned embodiments will be described in more detail in the following description of typical embodiments with reference to the following drawings in which:

Fig. 1 schematically illustrates a thickness measuring device according to an embodiment;

Figs. 2 schematically illustrates a thickness measuring device according to an embodiment;

Fig. 3 schematically illustrates a thickness measuring device according to an embodiment;

Figs. 4a to 4c schematically illustrate coating installations according to embodiments;

Fig. 5 schematically illustrates a coating installation according to an embodiment; and

Fig. 6 schematically illustrates a coating installation according to an embodiment.

It is contemplated that elements of one embodiment may be advantageously utilized in other embodiments without further recitation.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

Within the following description of the drawings, the same reference numbers refer to the same components. Generally, only the differences with respect to the individual embodiments are described.

Typical applications of embodiments described herein are for example layer deposition applications in the production of displays, such as LCD, TFT displays and OLED (Organic Light Emitting Diode), in solar wafer manufacturing and in semiconductor device production. Without limiting the scope, in the following the examples and embodiments are described referring to deposition of a vapor on a solar cell wafer in an inline production system for forming electrical contacts. The vapor may be produced using an evaporator and/or a sputtering device, thereby producing a vapor to be deposited on a substrate surface. Hence, without limiting the scope, in the following the terms "deposition", "deposit" and "deposited" relate to deposition of a vapor produced by evaporation, also referred to herein as "vapor deposition", and/or deposition of a vapor produced by sputtering, also referred to herein as "sputter deposition". The thickness measuring device of embodiments may include vacuum-compatible materials and the coating installation of embodiments may be a vacuum coating installation. The thickness measuring device and method according to embodiments described herein can also be applied to other coating devices and other coating procedures. For instance, embodiments of the thickness measuring device may be used for monitoring coating thicknesses, thickness uniformities or coating rates during evaporation of metals or other materials than metals, such as organic materials, as well as in CVD processes, PVD processes and sputtering applications.

In case of forming electrical contacts by evaporation or sputtering, layers with a thickness of several microns can be formed. For instance, metal layers of electrical contacts produced by PVD may be in a thickness range of 1 to 20 µm, and the desired thickness uniformity can be in a range of 5 to 10 %. Films with such thicknesses are not transparent and the resistance is too small to achieve acceptable results of a thickness and/or thickness uniformity measurement using optical transmission or sheet resistance measurements. Moreover, the signal-to-noise-ratio using optical transmission or sheet resistance measurements is not acceptable. Furthermore, profilometer devices are too slow for inline thickness and/or thickness uniformity measurements.

According to one embodiment, a thickness measuring device for measuring the thickness of a layer on a substrate surface of a substrate is provided, including multiple piezoelectric crystal elements, which are arranged in an array corresponding to multiple positions on the substrate surface and which are adapted to monitor the deposition rate of a vapor to be deposited on the substrate surface. In some embodiments, the thickness measuring device is provided in a coating installation, e.g. in an inline coating installation.

In a further embodiment, a method of measuring the thickness of a layer on a substrate surface of a substrate is provided, including providing multiple piezoelectric crystal elements arranged in an array corresponding to multiple positions on the substrate surface, producing a vapor of material to be deposited on the substrate surface, and measuring the deposition rate of the vapor by means of the multiple piezoelectric crystal elements. The vapor of material may be produced by evaporation, e.g. by heating a wire of the material, or sputtering.

Embodiments described herein allow for measuring the thickness of layers which are not transparent and have a small resistance. Furthermore, embodiments described herein allow for measuring the thickness of layers formed by PVD. E.g. using embodiments described herein, the thickness of metal layers of electrical contacts produced by evaporation can be measured, which are in a thickness range of several microns, e.g. 1 to 20 µm, and the thickness uniformity of such layers can be evaluated. For instance, a metal layer thickness uniformity in a range of 5 to 10 % can be measured by means of embodiments described herein. Furthermore, processes of embodiments described herein can be performed in situ and/or online, e.g. in an inline coating installation. Furthermore, embodiments described herein allow for a thickness measurement in which undesired influences of electric and/or magnetic fields, of continuous or alternating fields, of thermal radiation, and/or of particle radiation can be avoided or even prevented. This is for instance due to the interference-prone structure of the piezoelectric crystal elements. For example, the piezoelectric crystal elements of embodiments do not include sensitive electronics, which can be affected by electric and/or magnetic fields. Further, embodiments described herein can be used in or near evaporators, such as a thermal evaporator or an electron beam evaporator.

Without limiting the scope, the piezoelectric crystal elements included in embodiments described herein are quartz crystal monitors (QCM). However, other piezoelectric crystals than quartz may be included in the thickness measurement device of embodiments. QCMs, also referred to as quartz crystal micro balances, quartz monitors or quartz resonators, or other so called piezoelectric microbalances can be used for the determination of the deposition rate of a vapor on a surface. The measurement of the actual oscillating frequency of these oscillating piezoelectric crystals allows the conclusion on the actual deposition rate. The deposition rate measured by piezoelectric crystal elements of embodiments may also be referred to herein as coating rate.

In embodiments described herein, the multiple piezoelectric crystal elements can be provided on a carrier which can be supported and/or transported by a substrate support. Alternatively or in addition, all of or some of the multiple piezoelectric crystal elements can be fixed at or in an installation, for or in which the thickness measuring device is used. For instance, the multiple piezoelectric crystal elements can be fixed at the substrate support behind a transport plane of the substrates, such that they face the vapor source during transport of the at least one substrate through gaps between two substrates. In some embodiments, the vapor can be produced by a vapor source, e.g. an evaporator or a sputtering device. In further embodiments, the substrate surface has a width across which a layer thickness is to be measured, and the array of the multiple piezoelectric crystal elements has a length adapted to the width of the substrate surface.

According to some embodiments, when manufacturing for instance a backside contact of a solar cell by forming a layer, e.g. a metallic layer, on a backside of a substrate, the metallic layer is deposited by sputtering from a target or by vapor deposition, for instance in an inline vacuum deposition system. At least one additional layer on at least one of a frontside or backside of the substrate in the inline vacuum deposition system can be formed, wherein the metallic layer and the additional layer can be deposited without interrupting vacuum. A corresponding coating installation may be a vacuum treatment system, including at least one vacuum treatment chamber and at least one deposition tool configured for depositing a metallic layer on the backside of a substrate by sputtering deposition or vapor deposition. Another deposition tool may be installed for depositing at least one additional layer on at least one of a frontside or backside of the substrate in the inline vacuum deposition system without interrupting the vacuum.

At least one of the following steps can be used in some embodiments, the layer deposited on the substrate surface including or being e.g. a metal: evaporators of the metal are provided in subsequent vacuum treatment chambers, and the metal is evaporated in a vacuum treatment chamber until the metal in the first evaporator included therein is consumed. When one layer of the metallic layer is vapor deposited, the metal can be provided as a wire to the evaporator through a vacuum passage. When the metal in the first evaporator is consumed, the metal in the other vacuum treatment chamber can be evaporated with a second evaporator, without interrupting the vapor deposition. Then, in particular the first evaporator can be maintained, and subsequently, after the second evaporator is consumed, the first evaporator can continue evaporation and so on. Thereby, the throughput may be increased, since metal can be evaporated this way without interrupting the deposition process. When a sputter deposition is performed instead of a vapor deposition, the metal contact layer can be sputter deposited with at least one rotatable cathode each. With such a rotatable cathode, much more constant deposition conditions are created long-term, than e.g. with static planar cathodes. In particular, thereby, the deposition can be performed in a DC-sputter process, wherein also pulsated DC-sputtering or MF-sputtering (medium frequency sputtering of at least two targets) is possible, and can be performed in particular dynamically, this means during simultaneous substrate transport.

The substrate may be run along the deposition tools substantially vertically or substantially horizontally. When running substantially horizontally, apparatuses, in which the deposition tools are aligned vertically with reference to their deposition direction, and in which a horizontal substrate transport is performed, can be used, whereby the handling of the substrate during the transport is simplified, since it can be run e.g. over transport rolls. In embodiments, "inline processing" does not necessarily mean a physical transportation of the substrate from a vacuum chamber to the other, in order to deposit various layers, but also a passing through particular process steps without physical transportation of the substrate, this means e.g. the simultaneous deposition of layers on the front- or backside of the substrate. Put differently, "inline" also means that the substrate in the vacuum treatment apparatus is transported into a vacuum treatment chamber, rests in a position therein, and leaves the vacuum chamber and possibly the vacuum apparatus again, after the coating on the front- and/or on the backside has been effected. Certainly, the substrate can also be transported during the coating process. The throughput can be increased additionally, when several substrates, which are located in particular in a common carrier are simultaneously provided with the metallic layer.

In some embodiments, the layer to be formed on the substrate surface by vapor deposition or sputtering may be a metallic contact layer and the material to be deposited on the substrate surface may be chosen from aluminum, silver, molybdenum, copper and/or nickel, and a mixture of one or several of the preceding materials. These metals have very good contact properties, due to their electrical conductivity. Preferably, however, aluminum is to be used, since this material is low cost. The metal layer can be deposited with a thickness of 0.1 µm to 10 µm, such as 2 µm. Such thin layers may be sufficient, since the contact properties are much better, than with metallic layers, which have been deposited through a silk screening process. With these thin layers, there are also less problems with respect to a wafer bending, also with thin substrates.

According to some embodiments, between the substrate and the metallic contact layer, a passivation layer, made from a material from the group Sin:H, SiC:H, SiO2:H or a-Si:H, preferably SiN:H, may be deposited. Furthermore, a barrier layer, e.g. made from WTi, can be provided in a useful manner. In order to improve the soldering capabilities of the metallic contact layer, a layer that can be soldered can be deposited onto this layer in a useful manner. Said layer can have one or several layers from materials from the group silver (Ag), nickel (Ni), nickel vanadium alloy (NiV), nickel chromium alloy (NiCr), and chromium (Cr). Layers, as described herein, include also embodiments, in which there is no closed surface layer. The layer that can be soldered can e.g. also be provided structured, this means only partially covering the surface. These additional layers may also be deposited by PVD, wherein vapor deposition and also sputtering deposition are possible. In some embodiments, the contacting of a metallic layer on the surface of the substrate with the substrate can be performed through partial melting through an intense laser beam, so that a laser fired contact (LFC) is created. This method can also be applied when a passivation layer is present on the substrate surface between the substrate and the metallic layer.

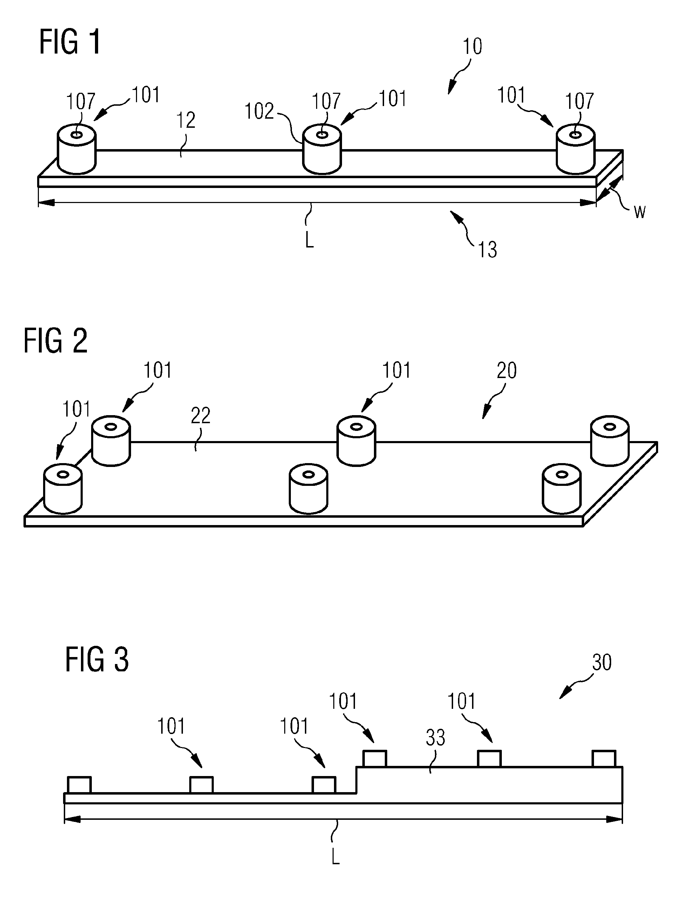

Fig. 1 schematically illustrates a perspective side view on a thickness measuring device 10, also called herein deposition rate monitor device 10, according to one embodiment. The thickness measuring device 10 includes as multiple piezoelectric crystal elements at least two QCMs 101, each having a housing 102. In the example of Fig. 1, three QCMs are arranged in a row on an elongated carrier 12 having a length L and a width W. Hence, Fig. 1 shows a perspective side view on a long side 13 of the thickness measuring device 10. The QCMs of the present example are positioned on the carrier 12 such that they are evenly distributed along the elongated carrier 12, two QCMs being positioned at opposite ends of the carrier 12. Each housing 102 has a vapor inlet aperture 107, which is provided centrally in one sidewall of the housing 102 opposite to the carrier 12.

The dimensions of the thickness measuring device 10 are chosen, such that the array of the multiple QCMs corresponds to multiple positions on the surface of a substrate to be measured. In some modifications of the present embodiment, the length L of the carrier 12 corresponds to a width or a length of a substrate to be measured. In variations of the present embodiment, which can be combined with any other embodiment described herein, the dimensions of the thickness measuring device 10, e.g. the width W of the carrier 12, is chosen such that the thickness measuring device 10 can be transported on a substrate transport system for transporting the substrate or substrates to be deposited with a vapor.

In some embodiments, the thickness measuring device, such as the device 10, may include a control device including or being a layer thickness extracting and/or comparison device (not shown in Fig.1). Thereby, values of the layer thickness and/or the layer thickness uniformity of a vapor material deposited along a substrate surface can be determined. This can be done by measuring the deposition rate of the vapor by means of changes of the oscillation frequency of the Quartz crystals inside of the housings 102. Each deposition rate measured by the multiple QCMs corresponds to a layer thickness value at a position on the substrate surface, and the multiple layer thicknesses can be compared for evaluating the uniformity of the layer thickness across a substrate surface.

According to embodiments, the piezoelectric crystal elements may be driven in a wired manner and/or may be controlled in a wired manner. For instance, the QCMs 101 of the embodiment shown in Fig. 1, may each include electrical connectors (not shown) for connecting each QCM to means for operating the QCM, such as a power supply and/or to the control device. In other embodiments, the multiple piezoelectric crystal elements may be driven in a wireless manner, e.g. battery powered, and/or may include means for wireless communication with the control device, for instance by infrared communication.

In some embodiments, the control device is adapted for controlling a vapor source, which generates the vapor to be deposited, depending on the deposition rate measured by at least one of the piezoelectric crystal elements. To this end, the vapor source and the thickness measuring device may be connected or may be connectable to the control device. In other embodiments, at least the thickness measuring device is adapted for wireless communication with the control device. In further embodiments, which can be combined with any other embodiment described herein, the deposition rate of the vapor source can be adjusted, e.g. by a feedback control. For instance, in some embodiments, the control device is adapted for controlling the vapor source depending on the deposition rate.

Since the thickness measuring device 10 shown in Fig. 1 includes a straight row of QCMs, it can be used to determine the layer thickness or layer thickness uniformity of a vapor material deposited on a substrate substantially corresponding to one dimension of the substrate, i.e. one dimensionally. In other embodiments, the multiple QCMs may be arranged in other patterns, such as one, two or even three dimensional patterns. Hence, according to embodiments, the layer thickness uniformity may be determined not only one dimensionally, but also two dimensionally or even three dimensionally. For instance, as schematically illustrated in Fig. 2, a thickness measuring device 20 according to one embodiment includes multiple QCMs 101 arranged in a two dimensional pattern, in this example in two parallel rows on a plate shaped elongated carrier 22. In a further embodiment, as schematically shown in Fig. 3 which is a lengthwise side view, a thickness measuring device 30 can be adapted to monitor the deposition rate of a vapor three dimensionally. To this end, the thickness measuring device 30 may for instance have two parallel rows of multiple QCMs evenly distributed on a profiled, in the present embodiment, a stepped carrier plate 33 in parallel to a length L thereof. The profiled surface shape of carrier plate 33 may correspond to a profiled surface of a substrate to be coated with a vapor.

In other embodiments, however, for determining the thickness of a layer on a profiled substrate surface, a one or two dimensionally monitoring thickness measuring device of embodiments can be used, and the corresponding control device may be adapted, e.g. programmed, to compensate for errors resulting from different vertical heights of a profiled substrate surface. For instance, data of different vertical heights of the substrate surface may be measured by sensors or may be known and entered into the control device, e.g. before measuring the deposition rate of the vapor. Further, a three dimensionally monitoring thickness measuring device of embodiments described herein can be used for determining layer thickness values of a layer on a flat or substantially planar substrate surface and the corresponding control device may be adapted, e.g. programmed, to compensate for errors resulting from different vertical heights of the three dimensionally monitoring thickness measuring device. Hence, in some embodiments, the control device may be adapted to compensate for errors resulting from offset positions, e.g. different levels, of at least one of the piezoelectric crystal elements of the thickness measuring device with respect to a corresponding position on the substrate surface.

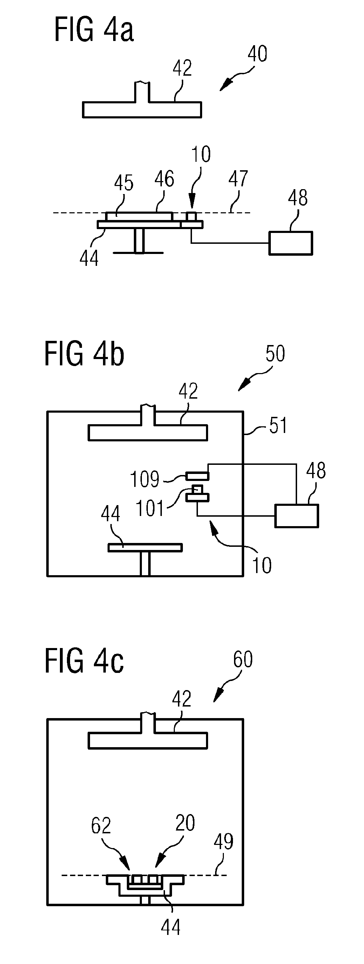

Fig. 4a schematically shows a coating installation 40 of embodiments, including a vapor source 42 and a substrate support 44. As shown in Fig. 4a, on the substrate support 44 an e.g. plate shaped substrate 45 having a substrate surface 46 can be positioned. The substrate surface 46 defines a surface plane 47 (shown with a dashed line in Fig. 4a). For measuring the layer thickness and/or the layer thickness uniformity of a vapor generated by vapor source 42, the thickness measuring device 10 shown in Fig. 1 is laterally attached to the substrate support 44. In Fig. 1, the thickness measuring device 10 and the substrate support 44 are shown with their long sides perpendicular to the plane of projection. In the present embodiment, a long side of the measuring device 10 is positioned adjacent to a long side of the substrate support. The length of the measuring device 10, i.e. the length of the carrier 12, may substantially correspond to a length of the substrate 46. In the present embodiment, the measuring device 10 is arranged in parallel to the length of the substrate support 44, such that at least two QCMs 101 are positioned in parallel to and/or in alignment with a lateral side of the substrate 45 to be coated. Thereby, the positions of at least two QCMs correspond to positions on the substrate surface 46. Further, the QCMs 101 of the measuring device 10 may be positioned in a vertical height below or corresponding to the surface plane 47, the vapor apertures of each QCM facing the vapor source 42. As a control device, a layer thickness extracting and/or comparison device 48 is connected to the thickness measuring device 10. In a variation of this embodiment, a second thickness measuring device 10 may be arranged in a mirror inverted manner on the opposite long side of the substrate support, such that both thickness measuring devices 10 are arranged in parallel to the substrate support.

When operating coating installation 40, a vapor is generated by vapor source 42 and deposited simultaneously on the substrate surface 46 and the Quartz crystals inside of the QCMs of the thickness measuring device 10. As a result, the oscillation frequencies of the Quartz crystals change and are correlated by control device 48 with the deposition rates of the vapor and the thicknesses of the layer of vapor material formed at multiple positions on the substrate surface. Consequently, since multiple QCMs are provided, multiple values of the layer thickness can be determined in situ, in the present example at the place of vapor deposition. Further, the multiple values of the layer thickness can be compared, providing a measure of the thickness uniformity of the layer of vapor material deposited on the substrate surface.

Fig. 4b illustrates as an embodiment a coating installation 50, having a housing 51 in which the vapor source 42, the substrate support 44 and the thickness measuring device 10 are provided. The measuring device 10 is provided laterally at a holder (not shown) at a side wall of the housing 51, in a height between the substrate support 44 and the vapor source 42, with its long sides in parallel to a length of the substrate support 44. In the present embodiment, the length of the measuring device 10 is adapted to the length of the substrate support 44 such that at least two QCMs of the measuring device are positioned in parallel to and/or aligned with a substrate to be coated. Since in the present example the vapor source 42 has a lateral overhang over the substrate support 44, the position of the thickness measuring device 10 can be chosen such that a substrate positioned on the substrate support is not shaded by the measuring device, but exposed to the vapor produced. In the present embodiment, the measuring device further has a shutter 109 to shield, e.g. shading or closing, the vapor aperture 107 of at least of the QCMs 101. Using the shutter 109, the measurement by at least one of the QCMs can be interrupted or stopped. The shutter 109 can be connected to the control device 48 along with the QCMs 101 of the measuring device 10, such that the shutter 109 can be moved automatically. In one example of operation of this embodiment, the layer thickness and/or the layer thickness uniformity is measured while the substrate is coated.

Fig. 4c schematically illustrates as a further embodiment a coating installation 60. In this embodiment, the thickness measuring device, e.g. the measuring device 20 shown in Fig. 2, is positioned in a recess 62 of the substrate support 44, the recess 62 being arranged centrally between two opposite sides of the substrate support 44. Thereby, as shown in Fig. 4c, the multiple QCMs of the measuring device 20 can be arranged in a vertical height that substantially corresponds to a support plane 49 defined by the support surface of the substrate support 44. Moreover, the multiple QCMs of the measuring device 20 are arranged in an area facing the vapor source 42, which corresponds to an area in which a substrate to be vapor deposited has been or will be arranged. According to examples of operating this embodiment, the deposition rate of the vapor produced by the vapor source, and thereby the layer thickness and/or the layer thickness uniformity of a layer of vapor material to be deposited on a substrate, can be measured in situ without the substrate, e.g. before and/or after a substrate is coated.

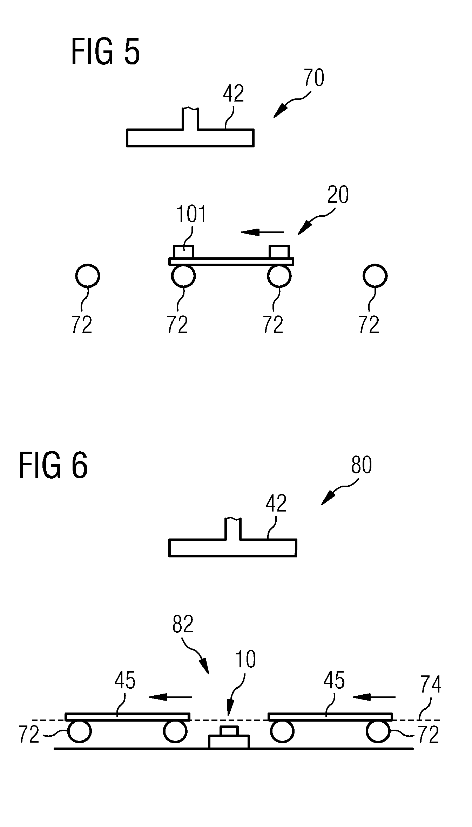

Fig. 5 schematically illustrates as another embodiment a coating installation 70, including the vapor source 42, and a substrate support being a transport system for transporting one or more substrates facing the vapor source 42 is provided. In the example shown in Fig. 5, the transport system includes a plurality of transport rolls 72 on which one or more substrates can be transported horizontally. The arrow shown in Fig, 5 indicates the transport direction of the transport system. According to the present embodiment of a coating installation, the thickness measuring device of any embodiments described herein can be transported through the coating installation on the transport rolls along with at least one substrate, or, as shown in Fig. 5, instead of a substrate. For instance, a substrate to be coated has a width and is transported with its width perpendicular to the transport direction, while a thickness measuring device is also transported on the transport system below the vapor source. In a particular example, the thickness measuring device includes an array of QCMs having a length adapted to, e.g. corresponding to, the width of the substrate and is transported with its length perpendicular to the transport direction. Hence, the multiple QCMs reproduce multiple layer thickness values corresponding to multiple positions on the substrate surface, and the thickness uniformity of the layer of material formed on the substrate surface can be evaluated by comparing the multiple thickness values.

In one example of operation of the embodiment shown in Fig. 5, the thickness measuring device 20, which includes two parallel rows of QCMs and is illustrated in Fig. 2, is transported below the operating vapor source 42 before and/or after one or more substrates has been transported through the coating installation and coated therein. The thickness measuring device 20 typically is positioned on the rolls 72 in alignment with the position, in which the substrate(s) is/are transported on the rolls 72. Both the substrate and the Quartz crystals of the QCMs of the measuring device 20 are coated with vapor material during their respective transport. In the present example, each QCM 101 includes electrical connectors (not shown) for connecting the QCM to a control device including a layer thickness extracting and/or comparison device (not shown in Fig. 5). The QCMs 101 are connected to the control device before and after transport through the coating installation 70. The control device may be adapted to compensate for different transport velocities, e.g. of the substrate(s) and the thickness measuring device. By measuring the oscillation frequencies of the QCMs before and after transport of the measuring device 20 through the coating installation 70, multiple values of the change of the oscillation frequencies are determined. Thereby, the deposition rate of the vapor generated by the vapor source and measured by each QCM is monitored inline and in situ, and is correlated with the thickness of the layer of material deposited on the substrate which has been or is to be coated. Since the array of QCMs of the measuring device 20 reveals in situ thickness values corresponding to multiple positions on the substrate surface, the thickness uniformity of the layer of material formed or to be formed on the substrate surface can be evaluated by comparing the multiple thickness values.

According to a variation of above example of operating the embodiment of Fig. 5, each QCM has means for wireless communication with the control device, which is provided outside of the coating installation. Hence, the QCMs are not connected to the control device before and after transport through the coating installation via electrical connections. Rather, the QCMs communicate with the control device during transport through the coating installation, thereby continuously providing values of the oscillation frequencies. Hence, the control device continuously monitors the deposition rate of each QCM and can, based thereon, determine in situ layer thickness values of the vapor material layer formed on the substrate(s) and in situ layer thickness variations across the substrate(s).

In one embodiment, which may be combined with any other embodiment described herein, a method of operating the thickness measuring device may include a calibration step by which a calibration of changes of the oscillation frequency of at least one of the multiple piezoelectric crystal elements with respect to the layer thickness on the substrate surface is performed. For instance, when operating the embodiment of Fig. 5, the calibration step can be performed by transporting the thickness measuring device 20 and a substrate through the coating installation 70 at a constant transport velocity. The change of oscillation frequency is measured using at least one of the QCMs. The thickness of the layer of vapor material deposited on the substrate surface can be measured externally after the substrate has been discharged from the coating installation 70, for instance using a profilometer, and correlated with the measured oscillation frequency change.

Fig. 6 schematically shows an embodiment of a coating installation 80 which differs from the one of Fig. 5 in that the thickness measuring device is not transported on the rolls 72 for measuring the layer thickness, but is installed, e.g. at a wall of the coating installation, between two rolls 72 below a substrate transport plane 74 defined by the transported substrates 45. According to one example, the transport rolls 72 each have a length perpendicular to the plane of projection and the thickness measuring device 10 shown in Fig. 1 is positioned with its length L in parallel to the transport rolls 72. In the present embodiment, each QCM 101 of the measuring device 10 is connected to means for operating the QCM (not shown), such as a power supply, and to the control device (not shown) for determining the layer thickness and the layer thickness uniformity. For instance, the QCMs can be connected to the power supply and the control device via a common coaxial transmission line. In some examples of the present embodiment, a substrate to be coated has a width and is transported with its width perpendicular to the transport direction. Hence, when the coating installation 80 is operated and at least two substrates are transported there through, the array of QCMs 101 of the measuring device 10 faces the vapor source during transport of the substrates through gaps 82 between two substrates, thereby monitoring the deposition rates of the vapor at multiple positions in parallel to the width of the substrates. Based thereon, the control device can determine in situ layer thickness values corresponding to multiple positions on the substrate surface and can evaluate the layer thickness uniformity across the width of the substrates.

Embodiments described herein allow for an in situ measurement of the thickness of layers formed by PVD, e.g. of metal layers of electrical contacts produced by evaporation, which are, for instance, in a thickness range of several microns, e.g. 1 to 20 µm, and of the thickness uniformity of such layers. "In situ" means, for instance, that the measurement or steps of the measurement are performed, implemented and/or initiated at or near locations, at which the vapor material is deposited on a substrate surface. Therefore, embodiments described herein can be used for inline thickness measurements and/or inline thickness uniformity measurements.

Furthermore, embodiments described herein allow for a thickness measurement in which undesired influences of electric and/or magnetic fields, of continuous or alternating fields, of thermal radiation, and/or of particle radiation can be avoided or even prevented. This is for instance due to the interference-prone structure of the piezoelectric crystal elements. For example, the piezoelectric crystal elements of embodiments do not include sensitive electronics, which can be affected by electric and/or magnetic fields. Further, embodiments described herein can be used in or near evaporators, such as a thermal evaporator or an electron beam evaporator. Moreover, according to embodiments described herein, the layer thickness of the material on the substrate surface can be determined by measuring the oscillation frequencies of the piezoelectric crystal elements before and after transport of the measuring device through the coating installation, e.g. in ambient atmosphere. Hence, the thickness measurement or thickness uniformity measurement can be performed independently from undesired influences of devices inside of the coating installation.

According to one embodiment, a thickness measuring device for measuring the thickness of a layer on a substrate surface of a substrate is provided, including multiple piezoelectric crystal elements, which are arranged in an array corresponding to multiple positions on the substrate surface and which are adapted to monitor the deposition rate of a vapor to be deposited on the substrate surface. In some embodiments, which can be combined with any other embodiment described herein, the thickness measuring device is provided in a coating installation, e.g. in an inline coating installation.

In some embodiments, which can be combined with any other embodiment described herein, the array of the thickness measuring device may be at least one element chosen from a row, a straight row, and an array arranged in a plane. In embodiments, which can be combined with any other embodiment described herein, the substrate surface has a width across which the thickness is to be measured, and the array has a length adapted to the width of the substrate surface. In the thickness measuring device of embodiments described herein, which can be combined with any other embodiment described herein, the array of the multiple piezoelectric crystal elements may be adapted to be arranged in a plane chosen from a plane corresponding to a plane of the substrate surface, a plane which is in parallel to a plane of the substrate surface, a plane corresponding to a transport plane of the substrate, and a plane which is in parallel to a transport plane of the substrate.

Further, in some embodiments, which can be combined with any other embodiment described herein, the array of the multiple piezoelectric crystal elements may be adapted to be positioned on, e.g. at, a substrate support for supporting and/or transporting the substrate. According to embodiments, which can be combined with any other embodiment described herein, the thickness measuring device may include a layer thickness extracting device connected to or connectable to the multiple piezoelectric crystal elements and adapted to extract the layer thickness from at least two of the piezoelectric crystal elements. In some embodiments, which can be combined with any other embodiment described herein, the thickness measuring device may include a layer thickness comparison device adapted to compare the layer thickness extracted from at least two of the piezoelectric crystal elements. Further, in some embodiments, which can be combined with any other embodiment described herein, the thickness measuring device includes at least one shutter adapted to shield at least one or all of the multiple piezoelectric crystal elements. In some embodiments, which can be combined with any other embodiment described herein, the thickness measuring device may be a thickness uniformity measuring device.

One embodiment provides a coating installation including a thickness measuring device for measuring the thickness of a layer on a substrate surface of a substrate, including multiple piezoelectric crystal elements, which are arranged in an array corresponding to multiple positions on the substrate surface and which are adapted to monitor the deposition rate of a vapor to be deposited on the substrate surface.

In a further embodiment, a method of measuring the thickness of a layer on a substrate surface of a substrate is provided, including providing multiple piezoelectric crystal elements arranged in an array corresponding to multiple positions on the substrate surface, producing a vapor of material to be deposited on the substrate surface, and measuring the deposition rate of the vapor by means of the multiple piezoelectric crystal elements. The vapor of material may be produced by evaporation or sputtering.

In embodiments described herein, the multiple piezoelectric crystal elements can be provided by means of a thickness measuring device according to any of the embodiments described herein. Further, in embodiments, which can be combined with any other embodiment described herein, the array of the multiple piezoelectric crystal elements may be arranged in a plane chosen from a plane corresponding to a plane of the substrate surface, a plane which is in parallel to a plane of the substrate surface, a plane corresponding to a transport plane of the substrate, and a plane which is in parallel to a transport plane of the substrate.

In embodiments, which can be combined with any other embodiment described herein, the multiple piezoelectric crystal elements can be provided on a carrier which can be supported and/or transported by the substrate support. Alternatively or in addition, all of or some of the multiple piezoelectric crystal elements can be fixed at or in an installation, for or in which the thickness measuring device is used. For instance, the multiple piezoelectric crystal elements can be fixed, e.g. at the substrate support, behind the transport plane of the substrates, such that they face the vapor source during transport of the at least one substrate through gaps between two substrates.

In some embodiments, which can be combined with any other embodiment described herein, the vapor can be produced by a vapor source, e.g. an evaporator or a sputtering device. At least one substrate can be transported on a substrate support, the substrate surface facing the vapor source, and the array of the multiple piezoelectric crystal elements can be positioned facing the vapor source. According to embodiments, which can be combined with any other embodiment described herein, the array of the multiple piezoelectric crystal elements can be supported and/or transported on the substrate support. In further embodiments, which can be combined with any other embodiment described herein, the array of the multiple piezoelectric crystal elements is provided in a position chosen from a position on the substrate support, a position on the substrate support instead of at least one substrate, a position on the substrate support in a gap between two substrates, a position facing the vapor source during transport of the at least one substrate, a position facing the vapor source after and before transport of the at least one substrate, and a position facing the vapor source during transport of the at least one substrate through gaps between two substrates.

In embodiments described herein, which can be combined with any other embodiment described herein, at least one of the following steps can be included: the deposition rate of the vapor on at least one of the multiple piezoelectric crystal elements is correlated with the layer thickness of the material on the substrate surface; the deposition rate of the vapor of material and/or the layer thickness of the material on the substrate surface is determined during or after transport of the at least one substrate; the deposition rate is determined by means of changes of oscillation frequency of the multiple piezoelectric crystal elements; a calibration of changes of oscillation frequency of at least one of the multiple piezoelectric crystal elements with respect to the layer thickness on the substrate surface is performed; changes of oscillation frequency of at least two of the multiple piezoelectric crystal elements are determined; the changes of oscillation frequency at least two of the multiple piezoelectric crystal elements are processed and/or compared; the layer thickness is extracted from at least two of the multiple piezoelectric crystal elements and/or compared; the layer thickness uniformity is determined; and/or the layer thickness is measured in situ.

In further embodiments, which can be combined with any other embodiment described herein, the substrate surface has a width across which the layer thickness is to be measured, and the array of the multiple piezoelectric crystal elements has a length and is positioned with its length in parallel to the width of the substrate surface.

According to embodiments, which can be combined with any other embodiment described herein, the vapor is produced in at least one process chosen from evaporation, sputtering, PVD, CVD, production of electrical contacts, production of electrical contacts for semiconductor devices, and production of contact layers of solar cells.

In further embodiments, a thickness measuring device of any of embodiments described herein or of a coating installation of any of embodiments described herein can be used in at least one method chosen from a coating method, evaporation, sputtering, PVD, CVD, production of electrical contacts, production of electrical contacts for semiconductor devices, production of contact layers of solar cells, a thickness uniformity measurement, and an in situ thickness uniformity measurement.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the examples of embodiments and embodiments or modifications thereof described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A thickness measuring device for measuring the thickness of a layer on a substrate surface of a substrate, comprising
multiple piezoelectric crystal elements, which are arranged in an array corresponding to multiple positions on the substrate surface and which are adapted to monitor the deposition rate of a vapor to be deposited on the substrate surface.

2. The thickness measuring device according to claim 1, wherein the array is at least one element chosen from a row, a straight row, and an array arranged in a plane.

3. The thickness measuring device of any of the preceding claims, wherein the substrate surface has a width across which the thickness is to be measured, and
the array has a length adapted to the width of the substrate surface.

4. The thickness measuring device of any of the preceding claims, wherein the array of the multiple piezoelectric crystal elements is adapted to be arranged in a plane chosen from a plane corresponding to a plane of the substrate surface, a plane which is in parallel to a plane of the substrate surface, a plane corresponding to a transport plane of the substrate, and a plane which is in parallel to a transport plane of the substrate.

5. The thickness measuring device of any of the preceding claims,
wherein the array of the multiple piezoelectric crystal elements is adapted to be positioned on a substrate support for supporting and/or transporting the substrate, and/or
wherein the thickness measuring device comprises a layer thickness extracting device connected to or connectable to the multiple piezoelectric crystal elements and adapted to extract the layer thickness from at least two of the piezoelectric crystal elements, and/or
wherein the thickness measuring device comprises a layer thickness comparison device adapted to compare the layer thickness extracted from at least two of the piezoelectric crystal elements, and/or
wherein the thickness measuring device comprises at least one shutter adapted to shield at least one or all of the multiple piezoelectric crystal elements, and/or
wherein the thickness measuring device is a thickness uniformity measuring device.

6. A coating installation comprising a thickness measuring device according to any of claims 1 to 5.

7. A method of measuring the thickness of a layer on a substrate surface of a substrate, comprising
providing multiple piezoelectric crystal elements arranged in an array corresponding to multiple positions on the substrate surface,
producing a vapor of material to be deposited on the substrate surface, and
measuring the deposition rate of the vapor by means of the multiple piezoelectric crystal elements.

8. The method of claim 7, wherein
the multiple piezoelectric crystal elements are provided by means of a thickness measuring device according to any of claims 1 to 5; and/or wherein the array of the multiple piezoelectric crystal elements is arranged in a plane chosen from a plane corresponding to a plane of the substrate surface, a plane which is in parallel to a plane of the substrate surface, a plane corresponding to a transport plane of the substrate, and a plane which is in parallel to a transport plane of the substrate.

9. The method of any of claims 7 and 8, wherein
the vapor is produced by a vapor source,
at least one substrate is transported on a substrate support, the substrate surface facing the vapor source, and
the array of the multiple piezoelectric crystal elements is positioned facing the vapor source.

10. The method of any of claims 7 to 9, wherein the array of the multiple piezoelectric crystal elements is supported and/or transported on the substrate support.

11. The method of any of claims 7 to 10, wherein the array of the multiple piezoelectric crystal elements is provided in a position chosen from a position on the substrate support, a position on the substrate support instead of at least one substrate, a position on the substrate support in a gap between two substrates, a position facing the vapor source during transport of the at least one substrate, a position facing the vapor source after and before transport of the at least one substrate, and a position facing the vapor source during transport of the at least one substrate through gaps between two substrates.

12. The method of any of claims 7 to 11,
wherein the deposition rate of the vapor on at least one of the multiple piezoelectric crystal elements is correlated with the layer thickness of the material on the substrate surface, and/or
wherein the deposition rate of the vapor of material and/or the layer thickness of the material on the substrate surface is determined during or after transport of the at least one substrate, and/or
wherein the deposition rate is determined by means of changes of oscillation frequency of the multiple piezoelectric crystal elements, and/or
wherein a calibration of changes of oscillation frequency of at least one of the multiple piezoelectric crystal elements with respect to the layer thickness on the substrate surface is performed, and/or
wherein changes of oscillation frequency of at least two of the multiple piezoelectric crystal elements are determined and/or the changes of oscillation frequency at least two of the multiple piezoelectric crystal elements are processed and/or compared, and/or
wherein the layer thickness is extracted from at least two of the multiple piezoelectric crystal elements and/or compared, and/or
wherein the layer thickness uniformity is determined, and/or
wherein the layer thickness is measured in situ.

13. The method of any of claims 7 to 12, wherein
the substrate surface has a width across which the layer thickness is to be measured, and
the array of the multiple piezoelectric crystal elements has a length and is positioned with its length in parallel to the width of the substrate surface.

14. The method of any of claims 7 to 13, wherein the vapor is produced in at least one process chosen from evaporation, sputtering, PVD, CVD, production of electrical contacts, production of electrical contacts for semiconductor devices, and production of contact layers of solar cells.

15. Use of a thickness measuring device of any of claims 1 to 5 or of a coating installation of claim 6 in at least one method chosen from a coating method, evaporation, sputtering, PVD, CVD, production of electrical contacts, production of electrical contacts for semiconductor devices, production of contact layers of solar cells, a thickness uniformity measurement, and an in situ thickness uniformity measurement.

## Amended claims

### Amended claims in accordance with Rule 137(2) EPC.

**1.** A thickness measuring device for measuring the thickness of a layer on a substrate surface of a substrate, comprising
multiple piezoelectric crystal elements (101), which are arranged in an array corresponding to multiple positions at the substrate surface and which are adapted to monitor the deposition rate of a vapor to be deposited on the substrate surface,
wherein the substrate surface has a width across which the thickness is to be measured, and
the array has a length corresponding to the width of the substrate surface.

**2.** The thickness measuring device according to claim 1, wherein the array is at least one element chosen from a row, a straight row, and an array arranged in a plane.

**3.** The thickness measuring device of any of the preceding claims, wherein the array of the multiple piezoelectric crystal elements is adapted to be arranged in a plane chosen from a plane corresponding to a plane of the substrate surface, a plane which is in parallel to a plane of the substrate surface, a plane corresponding to a transport plane of the substrate, and a plane which is in parallel to a transport plane of the substrate.

**4.** The thickness measuring device of any of the preceding claims, comprising at least one element chosen from:
the array of the multiple piezoelectric crystal elements being adapted to be positioned on a substrate support for supporting and/or transporting the substrate, the thickness measuring device comprising a layer thickness extracting device connected to or connectable to the multiple piezoelectric crystal elements and being adapted to extract the layer thickness from at least two of the piezoelectric crystal elements,
the thickness measuring device comprising a layer thickness comparison device adapted to compare the layer thickness extracted from at least two of the piezoelectric crystal elements,
the thickness measuring device comprising at least one shutter adapted to shield at least one or all of the multiple piezoelectric crystal elements,
and
the thickness measuring device being a thickness uniformity measuring device.

**5.** A coating installation comprising a thickness measuring device according to any of claims 1 to 4.

**6.** A method of measuring the thickness of a layer on a substrate surface of a substrate, comprising
providing multiple piezoelectric crystal elements (101) arranged in an array corresponding to multiple positions at the substrate surface, wherein the substrate surface has a width across which the thickness is to be measured, and the array has a length corresponding to the width of the substrate surface,
producing a vapor of material to be deposited on the substrate surface, and
measuring the deposition rate of the vapor by means of the multiple piezoelectric crystal elements.

**7.** The method of claim 6, wherein
the multiple piezoelectric crystal elements are provided by means of a thickness measuring device according to any of claims 1 to 4; and/or wherein the array of the multiple piezoelectric crystal elements is arranged in a plane chosen from a plane corresponding to a plane of the substrate surface, a plane which is in parallel to a plane of the substrate surface, a plane corresponding to a transport plane of the substrate, and a plane which is in parallel to a transport plane of the substrate.

**8.** The method of any of claims 6 and 7, wherein
the vapor is produced by a vapor source,
at least one substrate is transported on a substrate support, the substrate surface facing the vapor source, and
the array of the multiple piezoelectric crystal elements is positioned facing the vapor source.

**9.** The method of any of claims 6 to 8, wherein the array of the multiple piezoelectric crystal elements is supported and/or transported on the substrate support.

**10.** The method of any of claims 6 to 9, wherein the array of the multiple piezoelectric crystal elements is provided in a position chosen from a position on the substrate support, a position on the substrate support instead of at least one substrate, a position on the substrate support in a gap between two substrates, a position facing the vapor source during transport of the at least one substrate, a position facing the vapor source after and before transport of the at least one substrate, and a position facing the vapor source during transport of the at least one substrate through gaps between two substrates.

**11.** The method of any of claims 6 to 10, comprising at least one element chosen from:
a correlation of the deposition rate of the vapor on at least one of the multiple piezoelectric crystal elements with the layer thickness of the material on the substrate surface,
a determination of the deposition rate of the vapor of material and/or the layer thickness of the material on the substrate surface during or after transport of the at least one substrate,
a determination of the deposition rate by means of changes of oscillation frequency of the multiple piezoelectric crystal elements,
a calibration of changes of oscillation frequency of at least one of the multiple piezoelectric crystal elements with respect to the layer thickness on the substrate surface,
a determination of changes of oscillation frequency of at least two of the multiple piezoelectric crystal elements ,a processing and/or comparison of the changes of oscillation frequency at least two of the multiple piezoelectric crystal elements, and
an extraction and/or comparison of the layer thickness from at least two of the multiple piezoelectric crystal elements.

**12.** The method of any of claims 6 to 11,
wherein the layer thickness uniformity is determined, and/or
wherein the layer thickness is measured in situ.

**13.** The method of any of claims 6 to 12, wherein
the array of the multiple piezoelectric crystal is positioned with its length in parallel to the width of the substrate surface.

**14.** The method of any of claims 6 to 13, wherein the vapor is produced in at least one process chosen from evaporation, sputtering, PVD, CVD, production of electrical contacts, production of electrical contacts for semiconductor devices, and production of contact layers of solar cells.

**15.** Use of a thickness measuring device of any of claims 1 to 4 or of a coating installation of claim 5 in at least one method chosen from a coating method, evaporation, sputtering, PVD, CVD, production of electrical contacts, production of electrical contacts for semiconductor devices, production of contact layers of solar cells, a thickness uniformity measurement, and an in situ thickness uniformity measurement.
